# EUROPEAN PATENT APPLICATION

(11) **EP 2 133 379 A1**
(43) Date of publication of application: **16.12.2009**
(21) Application number: 08722763.3
(22) Date of filing: 25.03.2008
(51) Int. Cl.: C08G 59/24, C08J 5/24

(54) **EPOXY RESIN COMPOSITION**

(30) Priority: 26.03.2007 JP 2007078665
(71) Applicant: Sumitomo Chemical Company, Limited, Tokyo 104-8260 (JP)
(72) Inventor: TANAKA, Shinya, Toyono-gun Osaka 563-0103 (JP); TAKEZAWA, Yoshitaka Hitachi Research Laboratory, Hitachi, Ltd., Ibaraki 3191292 (JP)
(74) Representative: Vossius & Partner
(86) International application number: PCT/JP2008/055553
(87) International publication number: WO 2008/123237

(57) **Abstract**

A resin composition comprising an epoxy compound denoted by the formula (1): 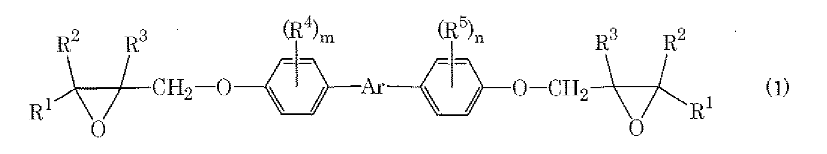 wherein R¹, R², R³, R⁴ and R⁵ denote a hydrogen atom or an alkyl group having 1 to 8 carbon atoms, m and n denote an integer of 0 to 4, Ar denotes any one of divalent groups denoted by the following formulas: 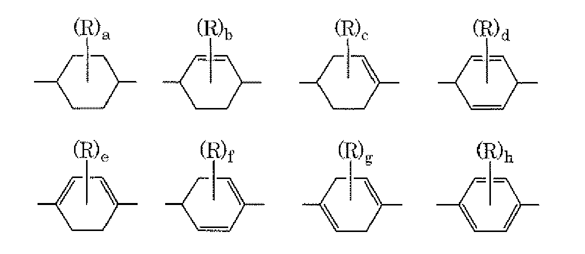 wherein R denotes a hydrogen atom or an alkyl group having 1 to 8 carbon atoms, and an epoxy compound denoted by the formula (2): 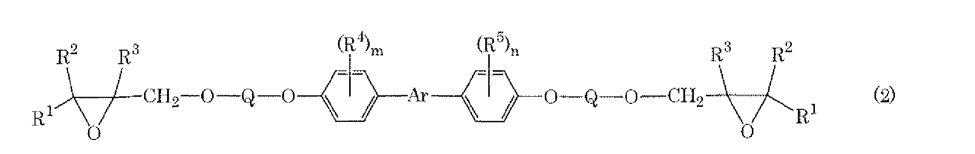 wherein Q denotes a straight-chain alkylene group having 1 to 8 carbon atoms, methylene groups composing said straight-chain alkylene group are optionally substituted with an alkyl group having 1 to 8 carbon atoms and -O- or -N(R⁶)- is optionally inserted between the methylene groups, wherein R⁶ denotes a hydrogen atom or an alkyl group having 1 to 8 carbon atoms.

## Description

### Technical Field

This application claims priority under the Paris Convention on Japanese Patent Application No. 2007-078665, the disclosure of which is incorporated by reference herein.
The present invention relates to a resin composition and a cured resin obtained by curing the resin composition.

### Background Art

U.S. Patent No. 5,811,504 and EP 1698625 A1 disclose that a cured resin obtained by curing an epoxy compound having a mesogen group using a curing agent such as a diamine compound exhibits liquid crystallinity.
Patent Document 1: U.S. Patent No. 5,811,504
Patent Document 2: EP 1698625 A1

### Disclosure of the Invention

The present invention provides:
<1> a resin composition comprising an epoxy compound denoted by the formula (1) (Hereinafter it may be abbreviated as an epoxy compound (1).): 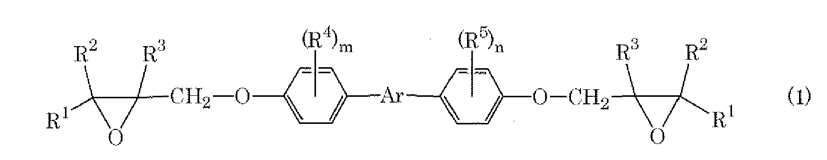
wherein R¹, R², R³, R⁴ and R⁵ are the same or different and each denotes a hydrogen atom or an alkyl group having 1 to 8 carbon atoms, m and n denote an integer of 0 to 4, and when m denotes an integer of 2 or more, all of R⁴ may be the same group or different groups, and when n denotes an integer of 2 or more, all of R⁵ may be the same group or different groups, Ar denotes any one of divalent groups denoted by the following formulas: 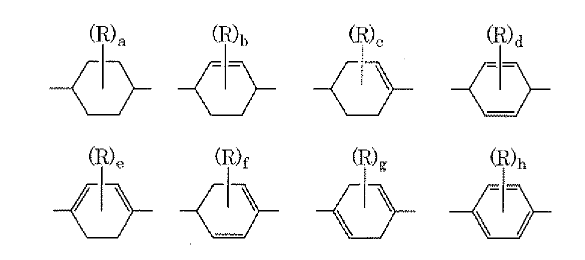 wherein R denotes a hydrogen atom or an alkyl group having 1 to 8 carbon atoms, a denotes an integer of 1 to 8, b, e and g denote an integer of 1 to 6, c denotes an integer of 1 to 7, d and h denote an integer of 1 to 4, f denotes an integer of 1 to 5, and when a to h denote an integer of 2 or more, all of R may be the same group or different groups, and an epoxy compound denoted by the formula (2) (Hereinafter it may be abbreviated as an epoxy compound (2).): 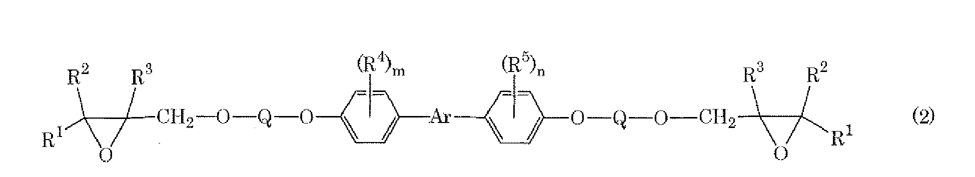 wherein R¹, R² R³, R⁴, R⁵, m, n and Ar are the same as defined above, Q denotes a straight-chain alkylene group having 1 to 8 carbon atoms, methylene groups composing said straight-chain alkylene group are optionally substituted with an alkyl group having 1 to 8 carbon atoms and -O- or -N(R⁶)-is optionally inserted between the methylene groups, wherein R⁶ denotes a hydrogen atom or an alkyl group having 1 to 8 carbon atoms;

<2> the resin composition according to <1>, wherein a weight ratio of the epoxy compound denoted by the formula (1) to the epoxy compound denoted by the formula (2), (epoxy compound denoted by the formula (1)/epoxy compound denoted by the formula (2)), is from 98/2 to 50/50;

<3> the resin composition according to <1>, wherein the epoxy compound denoted by the formula (1) is an epoxy compound denoted by the formula (3): 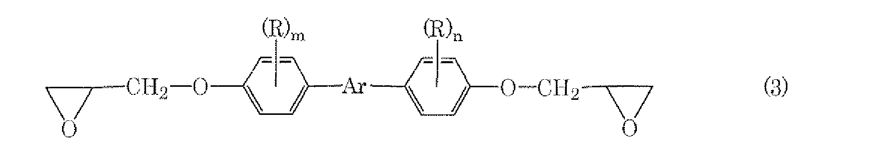 wherein Ar denotes any one of divalent groups denoted by the following formulas: 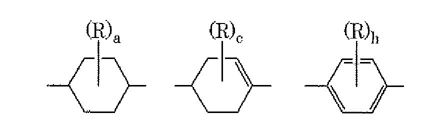 and R, a, c, h, m and n are the same as defined above;

<4> the resin composition according to <3>, wherein Ar is 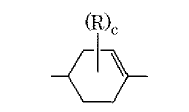 in the formula (3);

<5> the resin composition according to any one of <1> to <4>, further containing a curing agent;

<6> the resin composition according to <5>, further containing a filler;

<7> a cured resin obtained by curing the resin composition according to <5> or <6>;

<8> the cured resin according to <7>, wherein the curing temperature is from 120°C to 200°C;

<9> a cured resin obtained by curing the resin composition according to <6>;

<10> the cured resin according to <9>, wherein the curing temperature is from 120°C to 200°C; and

<11> a prepreg obtained by applying or impregnating a base material with the resin composition according to any one of <1> to <6> and semi-curing the applied or impregnated base material.

### Best Mode for Carrying Out the Invention

In the epoxy compound (1), examples of the alkyl group having 1 to 8 carbon atoms include a straight-chain or branched-chain alkyl group having 1 to 8 carbon atoms such as methyl, ethyl, n-propyl, isopropyl, n-butyl, isobutyl, sec-butyl, tert-butyl, n-pentyl, tert-amyl, n-hexyl, n-octyl, isooctyl and cyclooctyl group.

Examples of the divalent group denoted by the above formulas include cyclohexane-1,4-diyl, 2-cyclohexene-1,4-diyl, 1-cyclohexene-1,4-diyl, 1,4-cyclohexadiene-3,6-diyl, 1,3-cyclohexadiene-1,4-diyl, 1,3-cyclohexanediene-2,5-diyl, 1,4-cyclohexanediene-1,4-diyl, 2-methylcyclohexane-1,4-diyl, 2-methylcyclohexene-1,4-diyl, 1,4-phenylene, 3-methyl,-1,4-phenylene, 3-ethyl-1,4-phenylene, 3-n-propyl-1,4-phenylene, 3-isopropyl-1,4-pherylene, 3-n-butyl-1,4-phenylene, 3-sec-butyl-1,4-phenylene, 3-tert-butyl-1,4-phenylene, 3-n-pentyl-1,4-phenylene, 3-(1-methylbutyl)-1,4-phenylene, 3-(1,1-dimethylpropyl)-1,4-phenylene, 3-n-hexyl-1,4-phenylene, 3-(1-methylpentyl)-1,4-phenylene, 3-(2-methylpentyl)-1,4-phenylene, 3-(1-ethylbutyl)-1,4-phenylene, 3-(2-ethylbutyl)-1,4-phenylene, 3-cyclohexyl-1,4-phenylene, 3-n-heptyl-1,4-phenylene, 3-(1-methylcyclohexyl)-1,4-phenylene, 3-n-octyl-1,4-phenylene, 3-(2-ethylhexyl)-1,4-phenylene, 3,5-dimethyl-1,4-phenylene, 3,5-diethyl-1,4-phenylene, 3,5-di-n-propyl-1,4-phenylene, 3,5-diisopropyl-1,4-phenylene, 3,5-di-n-butyl-1,4-phenylene, 3,5-di-sec-butyl-1,4-phenylene, 3,5-di-tert-butyl-1,4-phenylene and 3,5-di-tert-amyl-1,4-phenylene group.

Among these epoxy compounds (1), preferred is an epoxy compound denoted by the following formula (3): 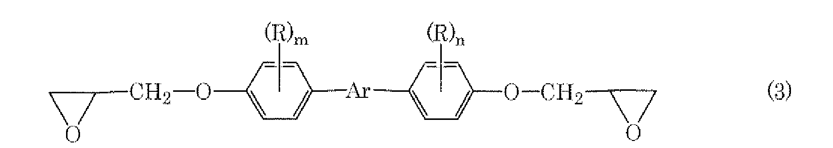 wherein Ar denotes any one of divalent groups denoted by the following formulas: 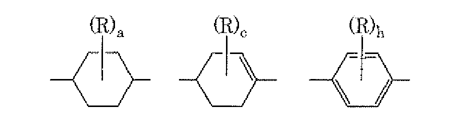 and R, a, c, h, m and n are the same as defined above, and among them, particularly preferred is an epoxy compound wherein Ar is

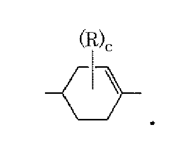

Examples of the epoxy compound (1) include:
1,4-bis{4-'(oxiranylmethoxy)phenyl}cyclohexane,
1-{2-methyl-4-(oxiranylmethoxy)phenyl}-4-{4-(oxiranylmethoxy)phenyl}cyclohexane,
1-{3-methyl-4-(oxiranylmethoxy)phenyl}-4-{4-(oxiranylmethoxy)phenyl}cyclohexane,
1-{3-ethyl-4-(oxiranylmethoxy)phenyl}-4-{4-(oxiranylmethoxy)phenyl}-cyclohexane,
1-{3-n-propyl-4-(oxiranylmethoxy)phenyl}-4-{4-(oxiranylmethoxy)phenyl}-cyclohexane,
l-{3-isopropyl-4-(oxiranylmethoxy)phenyl}-4-{4-(oxiranylmethoxy)phenyl}-cyclohexane,
1-{3-n-butyl-4-(oxiranylmethoxy)phenyl}-4-{4-(oxiranylmethoxy)phenyl}-cyclohexane,
1-{3-sec-butyl-4-(oxiranylmethoxy)phenyl}-4-{4-(oxiranylmethoxy)phenyl}-cyclohexane,
1-{3-tert-butyl-4-(oxiranylmethoxy)phenyl}-4-{4-(oxiranylmethoxy)phenyl}-cyclohexane,
1-{3-n-pentyl-4-(oxiranylmethoxy)phenyl}-4-{4-(oxiranylmethoxy)phenyl}-cyclohexane,
1-{3-tert-pentyl-4-(oxiranylmethoxy)phenyl}-4-{4-(oxiranylmethoxy)phenyl}-cyclohexane,
1-{3-n-hexy-4-(oxiranylmethoxy)phenyl}-4-{4-(oxiranylmethoxy)phenyl}-cyclohexane,
1-{3-(1-methylpentyl)-4-(oxiranylmethoxy)phenyl}-4-{4-(oxiranylmethoxy)phenyl}-cyclohexane,
1-{3-(1-ethylbutyl)-4-(oxiranylmethoxy)phenyl}-4-{4-(oxiranylmethoxy)phenyl}-cyclohexane,
1-{3-cyclohexyl-4-(oxiranylmethoxy)phenyl}-4-{4-(oxiranylmethoxy)phenyl}-cyclohexane,
1-{3-n-heptyl-4-(oxiranylmethoxy)phenyl}-4-{4-(oxiranylmethoxy)phenyl}-cyclohexane,
1-{3-n-octyl-4-(oxiranylmethoxy)phenyl}-4-{4-(oxiranylmethoxy)phenyl}-cyclohexane,
1-{3-(2-ethylhexyl)-4-(oxiranylmethoxy)phenyl}-4-{4-(oxiranylmethoxy)phenyl}-cyclohexane,
1-{3-tert-octyl-4-(oxiranylmethoxy)phenyl}-4-{4-(oxiranylmethoxy)phenyl}-cyclohexane,
1-{3-cyclooctyl-4-(oxiranylmethoxy)phenyl}-4-{4-(oxiranylmethoxy)phenyl}-cyclohexane,
1-{3-methyl-4-(2-methyl-oxiranylmethoxy)phenyl}-4-{4-(2-methyl-oxiranylmethoxy)phenyl}-cyclohexane,
1-{3-methyl-4-(3-methyl-oxiranylmethoxy)phenyl}-4-{4-(3-methyl-oxiranylmethoxy)phenyl}-cyclohexane,
1,4-bis{4-(oxiranylmethoxy)phenyl}-1-cyclohexene,
1-{2-methyl-4-(oxiranylmethoxy)phenyl}-4-{4-(oxiranylmethoxy)phenyl}-1-cyclohexene,
1-{3-methyl-4-(oxiranylmethoxy)phenyl}-4-{4-(oxiranylmethoxy)phenyl}-1-cyclohexene,
1-{3-ethyl-4-(oxiranylmethoxy)phenyl}-4-{4-(oxiranylmethoxy)phenyl}-1-cyclohexene,
1-{3-n-propyl-4-(oxiranylmethoxy)phenyl}-4-{4-(oxiranylmethoxy)phenyl}-1-cyclohexene,
1-{3-isopropyl-4-(oxiranylmethoxy)phenyl}-4-{4-(oxiranylmethoxy)phenyl}-1-cyclohexene,
1-{3-n-butyl-4-(oxiranylmethoxy)phenyl}-4-{4-(oxiranylmethoxy)phenyl}-1-cyclohexene,
1-{3-sec-butyl-4-(oxiranylmethoxy)phenyl}-4-{4-(oxiranylmethoxy)phenyl}-1-cyclohexene,
1-{3-tert-butyl-4-(oxiranylmethoxy)phenyl}-4-{4-(oxiranylmethoxy)phenyl}-1-cyclohexene,
1-{3-n-pentyl-4-(oxiranyimethoxy)phenyl}-4-{4-(oxiranylmethoxy)phenyl}-1-cyclohexene,
1-{3-tert-pentyl-4-(oxiranylmethoxy)phenyl}-4-{4-(oxiranylmethoxy)phenyl}-1-cyclohexene,
1-{3-n-hexyl-4-(oxiranylmethoxy)phenyl}-4-{4-(oxiranylmethoxy)phenyl}-1-cyclohexene,
1-{3-(1-methylpentyl)-4-(oxiranylmethoxy)phenyl}-4-{4-(oxiranylmethoxy)phenyl}-1-cyclohexene,
1-{3-(1-ethylbutyl)-4-(oxiranylmethoxy)phenyl}-4-{4-(oxiranylmethoxy)phenyl}-1-cyclohexene,
1-{3-cyclohexyl-4-(oxiranylmethoxy)phenyl}-4-{4-(oxiranylmethoxy)phenyl}-1-cyclohexene,
1-{3-n-heptyl-4-(oxiranylmethoxy)phenyl}-4-{4-(oxiranylmethoxy)phenyl}-1-cyclohexene,
1-{3-n-octyl-4-(oxiranylmethoxy)phenyl}-4-{4-(oxiranylmethoxy)phenyl}-1-cyclohexene,
1-{3-(2-ethylhexyl)-4-(oxiranylmethoxy)phenyl}-4-{4-(oxiranylmethoxy)phenyl}-1-cyclohexene,
1-{3-tert-octyl-4-(oxiranylmethoxy)phenyl}-4-{4-(oxiranylmethoxy)phenyl}-1-cyclohexene,
1-{3-cyclooctyl-4-(oxiranylmethoxy)phenyl}-4-{4-(oxiranylmethoxy)phenyl}-1-cyclohexene,
1-{3-methyl-4-(2-methyl-oxiranylmethoxy)phenyl}-4-{4-(2-methyl-oxiranylmethoxy)phenyl}-1-cyclohexene,
1-{3-methyl-4-(3-methyl-oxiranylmethoxy)phenyl}-4-{4-(3-methyl-oxiranylmethoxy)phenyl}-1-cyclohexene,
4-bis{4-(oxiranylmethoxy)phenyl}-2-cyclohexene,
1-{2-methyl-4-(oxiranylmethoxy)phenyl}-4-{4-(oxiranylmethoxy)phenyl}-2-cyclohexene,
1-{3-methyl-4-(oxiranylmethoxy)phenyl}-4-{4-(oxiranylmethoxy)phenyl}-2-cyclohexene,
1-{2-methyl-4-(oxiranylmethoxy)phenyl}-4-{4-(oxiranylmethoxy)phenyl}-2-cyclohexene,
1-{3-ethyl-4-(oxiranylmethoxy)phenyl}-4-{4-(oxiranylmethoxy)phenyl}-2-cyclohexene,
1-{3-n-propyl-4-(oxiranylmethoxy)phenyl}-4-{4-(oxiranylmethoxy)phenyl}-2-cyclohexene,
1-{3-isopropyl-4-(oxiranylmethoxy)phenyl}-4-{4-(oxiranylmethoxy)phenyl}-2-cyclohexene,
1-{3-n-butyl-4-(oxiranylmethoxy)phenyl}-4-{4-(oxiranylmethoxy)phenyl}-2-cyclohexene,
1-{3-sec-butyl-4-(oxiranylmethoxy)phenyl}-4-{4-(oxiranylmethoxy)phenyl}-2-cyclohexene,
1-{3-tert-butyl-4-(oxiranylmethoxy)phenyl}-4-{4-(oxiranylmethoxy)phenyl}-2-cyclohexene,
1-{3-n-pentyl-4-(oxiranylmethoxy)phenyl}-4-{4-(oxiranylmethoxy)phenyl}-2-cyclohexene,
1-{3-tert-pentyl-4-(oxiranylmethoxy)phenyl}-4-{4-(oxiranylmethoxy)phenyl}-2-cyclohexene,
1-{3-n-hexyl-4-(oxiranylmethoxy)phenyl}-4-{4-(oxiranylmethoxy)phenyl}-2-cyclohexene,
1-{3-(1-methylpentyl)-4-(oxiranylmethoxy)phenyl}-4-{4-(axiranylmeth_{Q}xy)phenyl}-2-cyclahexene,
1-{3-(1-ethylbutyl)-4-(oxiranylmethoxy)phenyl}-4-{4-(oxiranylmethoxy)phenyl}-2-cyclohexene,
1-{3-cyclohexyl-4-(oxiranylmethoxy)phenyl}-4-{4-(oxiranylmethoxy)phenyl}-2-cyclohexene,
1-{3-n-heptyl-4-(oxiranylmethoxy)phenyl}-4-{4-(oxiranylmethoxy)phenyl}-2-cyclohexene,
1-{3-n-octyl-4-(oxiranylmethoxy)phenyl}-4-{4-(oxiranylmethoxy)phenyl}-2-cyclohexene,
1-{3-(2-ethylhexyl)-4-(oxiranylmethoxy)phenyl}-4-{4-(oxiranylmethoxy)phenyl}-2-cyclohexene,
1-{3-tert-octyl-4-(oxiranylmethoxy)phenyl}-4-{4-(oxiranylmethoxy)phenyl}-2-cyclohexene,
1-{3-cyclooctyl-4-(oxiranylmethoxy)phenyl}-4-{4-(oxiranylmethoxy)phenyl}-2-cyclohexene,
1-{3-methyl-4-(2-methyl-oxiranylmethoxy)phenyl}-4-{4-(2-methyl-oxiranylmethoxy)phenyl}-2-cyclohexene,
1-{3-methyl-4-(3-methyl-oxiranylmethoxy)phenyl}-4-{4-(3-methyl-oxiranylmethoxy)phenyl}-2-cyclohexene,
1,4-bis{4-(oxiranylmethoxy)phenyl}-2,5-cyclohexadiene,
1-{2-methyl-4-(oxiranylmethoxy)phenyl}-4-{4-(oxiranylmethoxy)phenyl}-2,5-cyclohexadiene,
1-{3-methyl-4-(oxiranylmethoxy)phenyl}-4-{4-(oxiranylmethoxy)phenyl}-2,5-cyclohexadiene,
1-{3-ethyl-4-(oxiranylmethoxy)phenyl}-4-{4-(oxiranylmethoxy)phenyl}-2,5-cyclohexadiene,
1-{3-n-propyl-4-(oxiranylmethoxy)phenyl}-4-{4-(oxiranylmethoxy)phenyl}-2,5-cyclohexadiene,
1-{3-isopropyl-4-(oxiranylmethoxy)phenyl}-4-{4-(oxiranylmethoxy)phenyl}-2,5-cyclohexadiene,
1-{3-n-butyl-4-(oxiranylmethoxy)phenyl}-4-{4-(oxiranylmethoxy)phenyl}-2,5-cyclohexadiene,
1-{3-sec-butyl-4-(oxiranylmethoxy)phenyl}-4-{4-(oxiranylmethoxy)phenyl}-2,5-cyclohexadiene,
1-{3-tert-butyl-4-(oxiranylmethoxy)phenyl}-4-{4-(oxiranylmethoxy)phenyl}-2,5-cyclohexadiene,
1-{3-n-pentyl-4-(oxiranylmethoxy)phenyl}-4-{4-(oxiranylmethoxy)phenyl}-2,5-cyclohexadiene,
1-{3-tert-pentyl-4-(oxiranylmethoxy)phenyl}-4-{4-(oxiranylmethoxy)phenyl}-2,5-cyclohexadiene,
1-{3-n-hexyl-4-(oxiranylmethoxy)phenyl}-4-{4-(oxiranylmethoxy)phenyl}-2,5-cyclohexadiene,
1-{3-(1-methylpentyl)-4-(oxiranylmethoxy)phenyl}-4-{4-(oxiranylmethoxy)phenyl}-2,5-cyclohexadiene,
1-{3-(1-ethylbutyl)-4-(oxiranylmethoxy)phenyl}-4-{4-(oxiranylmethoxy)phenyl}-2,5-cyclohexadiene,
1-{3-cyclohexyl-4-(oxiranylmethoxy)phenyl}-4-{4-(oxiranylmethoxy)phenyl}-2,5-cyclohexadiene,
1-{3-n-heptyl-4-(oxiranylmethoxy)phenyl}-4-{4-(oxiranylmethoxy)phenyl}-2,5-cyclohexadiene,
1-{3-n-octyl-4-(oxiranylmethoxy)phenyl}-4-{4-(oxiranylmethoxy)phenyl}-2,5-cyclohexadiene,
1-{3-(2-ethylhexyl)-4-(oxiranylmethoxy)phenyl}-4-{4-(oxiranylmethoxy)phenyl}-2,5-cyclohexadiene,
1-{3-tert-octyl-4-(oxiranylmethoxy)phenyl}-4-{4-(oxiranylmethoxy)phenyl}-2,5-cyclohexadiene,
1-{3-cyclooctyl-4-(oxiranylmethoxy)phenyl}-4-{4-(oxiranylmethoxy)phenyl}-2,5-cyclohexadiene,
1-{3-methyl-4-(2-methyl-oxiranylmethoxy)phenyl}-4-{4-(2-methyl-oxiranylmethoxy)phenyl}-2,5-cyclohexadiene,
1-{3-methyl-4-(3-methyl-oxiranylmethoxy)phenyl}-4-{4-(3-methyl-oxiranylmethoxy)phenyl}-2,5-cyclohexadiene,
4-bis{4-(oxiranylmethoxy)phenyl}-1,5-cyclohexadiene,
1-{2-methyl-4-(oxiranylmethoxy)phenyl}-4-{4-(oxiranylmethoxy)phenyl}-1,5-cyclohexadiene,
1-{3-methyl-4-(oxiranylmethoxy)phenyl}-4-{4-(oxiranylmethoxy)phenyl}-1,5-cyclohexadiene,
1-{3-ethyl-4-(oxiranylmethoxy)phenyl}-4-{4-(oxiranylmethoxy)phenyl}-1,5-cyclohexadiene,
1-{3-n-propyl-4-(oxiranylmethoxy)phenyl}-4-{4-(oxiranylmethoxy)phenyl}-1,5-cyclohexadiene,
1-{3-isopropyl-4-(oxiranylmethoxy)phenyl}-4-{4-(oxiranylmethoxy)phenyl}-1,5-cyclohexadiene,
1-{3-n-butyl-4-(oxiranylmethoxy)phenyl}-4-{4-(oxiranylmethoxy)phenyl}-1,5-cyclohexadiene,
1-{3-sec-butyl-4-(oxiranylmethoxy)phenyl}-4-{4-(oxiranylmethoxy)phenyl}-1,5-cyclohexadiene,
1-{3-tert-butyl-4-(oxiranylmethoxy)phenyl}-4-{4-(oxiranylmethoxy)phenyl}-1,5-cyclohexadiene,
1-{3-n-pentyl-4-(oxiranylmethoxy)phenyl}-4-{4-(oxiranylmethoxy)phenyl}-1,5-cyclohexadiene,
1-{3-tert-pentyl-4-(oxiranylmethoxy)phenyl}-4-{4-(oxiranylmethoxy)phenyl}-1,5-cyclohexadiene,
1-{3-n-hexyl-4-(oxiranylmethoxy)phenyl}-4-{4-(oxiranylmethoxy)phenyl}-1,5-cyclohexadiene,
1-{3-(1-methylpentyl)-4-(oxiranylmethoxy)prenyl}-4-{4-(oxiranylmethoxy)phenyl}-1,5-cyclohexadiene,
1-{3-(1-ethylbutyl)-4-(oxiranylmethoxy)phenyl}-4-{4-(oxiranylmethoxy)phenyl}-1,5-cyclohexadiene,
1-{3-cyclohexyl-4-(oxiranylmethoxy)phenyl}-4-{4-(oxiranylmethoxy)phenyl}-1,5-cyclohexadiene,
1-{3-n-heptyl-4-(oxiranylmethoxy)phenyl}-4-{4-(oxiranylmethoxy)phenyl}-1,5-cyclohexadiene,
1-{3-n-octyl-4-(oxiranylmethoxy)phenyl}-4-{4-(oxiranylmethoxy)phenyl}-1,5-cyclohexadiene,
1-{3-(2-ethylhexyl)-4-(oxiranylmethoxy)phenyl}-4-{4-(oxiranylmethoxy)phenyl}-1,5-cyclohexadiene,
1-{3-tert-octyl-4-(oxiranylmethoxy)phenyl}-4-{4-(oxiranylmethoxy)phenyl}-2,5-cyclohexadiene,
1-{3-cyclooctyl-4-(oxiranylmethoxy)phenyl}-4-{4-(oxiranylmethoxy)phenyl}-1,5-cyclohexadiene,
1-{3-methyl-4-(2-methyl-oxiranylmethoxy)phenyl}-4-{4-(2-methyl-oxiranylmethoxy)phenyl}-1,5-cyclohexadiene,
1-{3-methyl-4-(3-methyl-oxiranylmethoxy)phenyl}-4-{4-(3-methyl-oxiranylmethoxy)phenyl}-1,5-cyclohexadiene,
4-bis{4-(oxiranylmethoxy)phenyl}-1,4-cyclohexadiene,
1-{2-methyl-4-(oxiranylmethoxy)phenyl}-4-{4-(oxiranylmethoxy)phenyl}-1,4-cyclohexadiene,
1-{3-methyl-4-(oxiranylmethoxy)phenyl}-4-{4-(oxiranylmethoxy)phenyl}-1,4-cyclohexadiene,
1-{3-ethyl-4-(oxiranylmethoxy)phenyl}-4-{4-(oxiranylmethoxy)phenyl}-1,4-cyclohexadiene,
1-{3-n-propyl-4-(oxiranylmethoxy)phenyl}-4-{4-(oxiranylmethoxy)phenyl}-1,4-cyclohexadiene,
1-{3-isopropyl-4-(oxiranylmethoxy)phenyl}-4-{4-(oxiranylmethoxy)phenyl}-1,4-cyclohexadiene,
1-{3-n-butyl-4-(oxiranylmethoxy)phenyl}-4-{4-(oxiranylmethoxy)phenyl}-1,4-cyclohexadiene,
1-{3-sec-butyl-4-(oxiranylmethoxy)phenyl}-4-{4-(oxiranylmethoxy)phenyl}-1,4-cyclohexadiene,
1-{3-tert-butyl-4-(oxiranylmethoxy)phenyl}-4-{4-(oxiranylmethoxy)phenyl}-1,4-cyclohexadiene,
1-{3-n-pentyl-4-(oxiranylmethoxy)phenyl}-4-{4-(oxiranylmethoxy)phenyl}-1,4-cyclohexadiene,
1-{3-tert-pentyl-4-(oxiranylmethoxy)phenyl}-4-{4-(oxiranylmethoxy)phenyl}-1,4-cyclohexadiene,
1-{3-n-hexyl-4-(oxiranylmethoxy)phenyl}-4-{4-(oxiranylmethoxy)phenyl}-1,4-cyclohexadiene,
1-{3-(1-methylpentyl)-4-(oxiranylmethoxy)phenyl}-4-{4-(oxiranylmethoxy)phenyl}-1,4-cyclohexadiene,
1-{3-(1-ethylbutyl)-4-(oxiranylmethoxy)phenyl}-4-{4-(oxiranylmethoxy)phenyl}-1,4-cyclohexadiene,
1-{3-cyclohexyl-4-(oxiranylmethoxy)phenyl}-4-{4-(oxiranylmethoxy)phenyl}-1,4-cyclohexadiene,
1-{3-n-heptyl-4-(oxiranylmethoxy)phenyl}-4-{4-(oxiranylmethoxy)phenyl}-1,4-cyclohexadiene,
1-{3-n-octyl-4-(oxiranylmethoxy)phenyl}-4-{4-(oxiranylmethoxy)phenyl}-1,4-cyclohexadiene,
1-{3-(2-ethylhexyl)-4-(oxiranylmethoxy)phenyl}-4-{4-(oxiranylmethoxy)phenyl}-1,4-cyclohexadiene,
1-{3-tert-octyl-4-(oxiranylmethoxy)phenyl}-4-{4-(oxiranylmethoxy)phenyl}-1,4-cyclohexadiene,
1-{3-cyclooctyl-4-(oxiranylmethoxy)phenyl}-4-{4-(oxiranylmethoxy)phenyl}-1,4-cyclohexadiene,
1-{3-methyl-4-(2-methyl-oxiranylmethoxy)phenyl}-4-{4-(2-methyl-oxiranylmethoxy)phenyl}-1,4-cyclohexadiene,
1-{3-methyl-4-(3-methyl-oxiranylmethoxy)phenyl}-4-{4-(3-methyl-oxiranylmethoxy)phenyl}-1,4-cyclohexadiene,
4-bis{4-(oxiranylmethoxy)phenyl}-1,3-cyclohexadiene,
1-{2-methyl-4-(oxiranylmethoxy)phenyl}-4-{4-(oxiranylmethoxy)phenyl}-1,3-cyclohexadiene,
1-{3-methyl-4-(oxiranylmethoxy)phenyl}-4-{4-(oxiranylmethoxy)phenyl}-1,3-cyclohexadiene,
1-{3-ethyl-4-(oxiranylmethoxy)phenyl}-4-{4-(oxiranylmethoxy)phenyl}-1,3-oyclohexadiene,
1-{3-n-propyl-4-(oxiranylmethoxy)phenyl}-4-{4-(oxiranylmethoxy)phenyl}-1,3-cyclohexadiene,
1-{3-isopropyl-4-(oxiranylmethoxy)phenyl}-4-{4-(oxiranylmethoxy)phenyl}-1,3-cyclohexadiene,
1-{3-n-butyl-4-(oxiranylmethoxy)phenyl}-4-{4-(oxiranylmethoxy)phenyl}-1,3-cyclohexadiene,
1-{3-sec-butyl-4-(oxiranylmethoxy)phenyl}-4-{4-(oxiranylmethoxy)phenyl}-1,3-cyclohexadiene,
1-{3-tert-butyl-4-(oxiranylmethoxy)phenyl}-4-{4-(oxiranylmethoxy)phenyl}-1,3-cyclohexadiene,
1-{3-n-pentyl-4-(oxiranylmethoxy)phenyl}-4-{4-(oxiranylmethoxy)phenyl}-1,3-cyclohexadiene,
1-{3-tert-pentyl-4-(oxiranylmethoxy)phenyl}-4-{4-(oxiranylmethoxy)phenyl}-1,3-cyclohexadiene,
1-{3-n-hexyl-4-(oxiranylmethoxy)phenyl}-4-{4-(oxiranylmethoxy)phenyl}-1,3-cyclohexadiene,
1-{3-(1-methylpentyl)-4-(oxiranylmethoxy)phenyl}-4-{4-(oxiranylmethoxy)phenyl}-1,3-cyclohexadiene,
1-{3-(1-ethylbutyl)-4-(oxiranylmethoxy)phenyl}-4-{4-(oxiranylmethoxy)phenyl}-1,3-cyclohexadiene,
1-{3-cyclohexyl-4-(oxiranylemthoxy)phenyl}-4-{4-(oxiranylmethoxy)phenyl}-1,3-cyclohexadiene,
1-{3-n-heptyl-4-(oxiranylmethoxy)phenyl}-4-{4-(oxiranylmethoxy)phenyl}-1,3-cyclohexadiene,
1-{3-n-octyl-4-(oxiranylmethoxy)phenyl}-4-{4-(oxiranylmethoxy)phenyl}-1,3-cyclohexadiene,
1-{3-(2-ethylhexyl)-4-(oxiranylmethoxy)phenyl}-4-{4-(oxiranylmethoxy)phenyl}-1,3-cyclohexadiene,
1-{3-tert-octyl-4-(oxiranylmethoxy)phenyl}-4-{4-(oxiranylmethoxy)phenyl}-1,3-cyclohexadiene,
1-{3-cyclooctyl-4-(oxiranylmethoxy)phenyl}-4-{4-(oxiranylmethoxy)phenyl}-1,3-cyclohexadiene,
1-{3-methyl-4-(2-methyl-oxiranylmethoxy)phenyl}-4-{4-(2-methyl-oxiranylmethoxy)phenyl}-1,3-cyclohexadiene,
1-{3-methyl-4-(3-methyl-oxiranylmethoxy)phenyl}-4-{4-(3-methyl-oxiranylmethoxy)phenyl}-1,3-cyclohexadiene,
4-bis{4-(oxiranylmethoxy)phenyl}benzene,
1-{2-methyl-4-(oxiranylmethoxy)phenyl}-4-{4-(oxiranylmethoxy)phenyl}benzene,
1-{3-methyl-4-(oxiranylmethoxy)phenyl}-4-{4-(oxiranylmethoxy)phenyl}benzene,
1-{3-ethyl-4-(oxiranylmethoxy)phenyl}-4-{4-(oxiranylmethoxy)phenyl}-benzene,
1-{3-n-propyl-4-(oxiranylmethoxy)phenyl}-4-{4-(oxiranylmethoxy)phenyl}-benzene,
1-{3-isopropyl-4-(oxiranylmethoxy)phenyl}-4-{4-(oxiranylmethoxy)phenyl}-benzene,
1-{3-n-butyl-4-(oxiranylmethoxy)phenyl}-4-{4-(oxiranylmethoxy)phenyl}-benzene,
1-{3-sec-butyl-4-(oxiranylmethoxy)phenyl}-4-{4-(oxiranylmethoxy)phenyl}-benzene,
1-{3-tert-butyl-4-(oxiranylmethoxy)phenyl}-4-{4-(oxiranylmethoxy)phenyl}-benzene,
1-{3-n-pentyl-4-(oxiranylmethoxy)phenyl}-4-{4-(oxiranylmethoxy)phenyl}-benzene,
1-{3-tert-pentyl-4-(oxiranylmethoxy)phenyl}-4-{4-(oxiranylmethoxy)phenyl}-benzene,
1-{3-n-hexyl-4-(oxiranylmethoxy)phenyl}-4-{4-(oxiranylmethoxy)phenyl}-benzene,
1-{3-(1-methylpentyl)-4-(oxiranylmethoxy)phenyl}-4-{4-(oxiranylmethoxy)phenyl}-benzene,
1-{3-(1-ethylbutyl)-4-(oxiranylmethoxy)phenyl}-4-{4-(oxiranylmethoxy)phenyl}-benzene,
1-{3-cyclohexyl-4-(oxiranylmethoxy)phenyl}-4-{4-(oxiranylmethoxy)phenyl}-benzene,
1-{3-n-heptyl-4-(oxiranylmethoxy)phenyl}-4-{4-(oxiranylmethoxy)phenyl}-benzene,
1-{3-n-octyl-4-(oxiranylmethoxy)phenyl}-4-{4-(oxiranylmethoxy)phenyl}-benzene,
1-{3-(2-ethylhexyl)-4-(oxiranylmethoxy)phenyl}-4-{4-(oxiranylmethoxy)phenyl}-benzene,
1-{3-tert-octyl-4-(oxiranylmethoxy)phenyl}-4-{4-(oxiranylmethoxy)phenyl}-benzene,
1-{3-cyclooctyl-4-(oxiranylmethoxy)phenyl}-4-{4-(oxiranylmethoxy)phenyl}-benzene,
1-{3-methyl-4-(2-methyl-oxiranylmethoxy)phenyl}-4-{4-(2-methyl-oxiranylmethoxy)phenyl}-benzene and
1-{3-methyl-4-(3-methyl-oxiranylmethoxy)phenyl}-4-{4-(3-methyl-oxiranylmethoxy)phenyl}-benzene.

Among these epoxy compounds,
1,4-bis{4-(oxiranylmethoxy)phenyl}-1-cyclohexene,
1-{3-methyl-4-(oxiranylmethoxy)phenyl}-4-{4-(oxiranylmethoxy)phenyl}-1-cyclohexene,
1-{3-ethyl-4-(oxiranylmethoxy)phenyl}-4-{4-(oxiranylmethoxy)phenyl}-1-cyclohexene,
1-{3-n-propyl-4-(oxiranylmethoxy)phenyl}-4-{4-(oxiranylmethoxy)phenyl}-1-cyclohexene,
1-{3-isopropyl-4-(oxiranylmethoxy)phenyl}-4-{4-(oxiranylmethoxy)phenyl}-1-cyclohexene,
1-{3-n-butyl-4-(oxiranylmethoxy)phenyl}-4-{4-(oxiranylmethoxy)phenyl}-1-cyclohexene,
1-{3-sec-butyl-4-(oxiranylmethoxy)phenyl}-4-{4-(oxiranylmethoxy)phenyl}-1-cyclohexene,
1-{3-tert-butyl-4-(oxiranylmethoxy)phenyl}-4-{4-(oxiranylmethoxy)phenyl}-1-cyclohexene,
1,4-bis{4-(oxiranylthoxyethoxy)phenyl}-1-cyclohexene,
1-{3-methyl-4-(oxiranylmethoxyethoxy)phenyl}-4-{4-(oxiranylmethoxyethoxy)phenyl}-1-cyclohexene,
1-{3-ethyl-4-(oxiranylmethoxyethoxy)phenyl}-4-{4-(oxiranylmethoxyethoxy)phenyl}-1-cyclohexene,
1-{3-n-propyl-4-(oxiranylmethoxyethoxy)phenyl}-4-{4-(oxiranylmethoxyethoxy)phenyl}-1-cyclohexene,
1-{3-isopropyl-4-(oxiranylmethoxyethoxy)phenyl}-4-{4-(oxiranylmethoxyethoxy)phenyl}-1-cyclohexene,
1-{3-n-butyl-4-(oxiranylmethoxyethoxy)phenyl}-4-{4-(oxiranylmethoxyethoxy)phenyl}-1-cyclohexene,
1-{3-sec-butyl-4-(oxiranylmethoxyethoxy)phenyl}-4-{4-(oxiranylmethoxyethoxy)phenyl}-1-cyclohexene and
1-{3-tert-butyl-4-(oxiranylmethoxyethoxy)phenyl}-4-{4-(oxiranylmethoxyethoxy)phenyl}-1-cyclohexene are preferred.
The epoxy compound (1) can be produced, for example, by the method described in EP 1698625 A1.

Examples of the straight-chain alkylene group having 1 to 8 carbon atoms in the epoxy compound (2) include groups formed by bonding 1 to 8 methylene groups linearly, such as methylene, ethylene, trimethylene, tetramethylene, hexamethylene and octamethylene group. The methylene groups composing the straight-chain alkylene group having 1 to 8 carbon atoms are optionally substituted with an alkyl group having 1 to 8 carbon atoms and -O- or -N(R⁶)- is optionally inserted between the methylene groups, and specific examples thereof include 2-methyltrimethylene, 1,2-dimethylpropylene, 3-oxatetramethylene and 3-oxapentamethylene group. Among these groups, a straight-chain alkylene group having 1 to 4 carbon atoms is preferred.

Examples of the alkyl group having 1 to 8 carbon atoms include a straight-chain or branched-chain alkyl group having 1 to 8 carbon atoms such as methyl, ethyl, n-propyl, isopropyl, n-butyl, isobutyl, sec-butyl, tert-butyl, n-pentyl, tert-amyl, n-hexyl, n-octyl, isooctyl and cyclooctyl group.

Examples of the epoxy compound (2) include:
1,4-bis{4-(oxiranylethoxy)phenyl}-1-cyclohexene,
1-{3-methyl-4-(oxiranylethoxy)phenyl}-4-{4-(oxiranylethoxy)phenyl}-1-cyclohexene,
1,4-bis{4-(3-oxiranylpropoxy)phenyl}-1-cyclohexene,
1-{3-methyl-4-(3-oxiranylpropoxy)phenyl}-4-{4-(3-oxiranylpropoxy)phenyl}-1-cyclohexene,
1,4-bis{4-(4-oxiranylbutoxy)phenyl}-1-cyclohexene,
1-{3-methyl-4-(4-oxiranylbutoxy)phenyl}-4-{4-(4-oxiranylbutoxy)phenyl}-1-cyclohexene,
1,4-bis{4-(5-oxiranylpentyloxy)pnenyl}-1-cyclohexene,
1-{3-methyl-4-(5-oxiranylpentyloxy)phenl}-4-{4-(5-oxiranylpentyloxy)phenyl}-1-cyclohexene,
1,4-bis{4-(6-oxiranylhexyloxy)phenyl}-1-cyclohexene,
1-{3-methyl-4-(6-oxiranylhexyloxy)phenyl}-4-{4-(6-oxiranylhexyloxy)phenyl}-1-cyclohexene,
1,4-bis{4-(8-oxiranyloctyloxy)phenyl}-1-cyclohexene,
1-{3-methyl-4-(8-oxiranyloctyloxy)phenyl}-4-{4-(8-oxiranyloctyloxy)phenyl}-1-cyclchexene,
1,4-bis{4-(oxiranylmethoxyethoxy)phenyl}-1-cyclohexene,
1-{3-methyl-4-(oxiranylmethoxyethoxy)phenyl}-4-{4-(oxiranylmethoxyethoxy)phenyl}-1-cyclohexene,
1,4-bis{4-(2-methyl-oxiranyl)methoxyethoxyphenyl}-1-cyclohexene,
1-{3-methyl-4-(2-methyl-oxiranyl)methoxyethoxyphenyl}-4-{4-(2-methyl-oxiranyl)methoxyethoxyphenyl}-1-cyclohexene,
1,4-bis{4-(3-methyl-oxiranyl)methoxyethoxyphenyl}-1-cyclohexene,
1-{3-methyl-4-(3-methyl-oxiranyl)methoxyethoxyphenyl}-4-{4-(3-methyl-oxiranyl)methoxyethoxyphenyl}-1-cyclohexene,
1,4-bis{4-(oxiranylmethoxyethoxy)phenyl}-benzene,
1-{3-methyl-4-(oxiranylmethoxyethoxy)phenyl}-4-{4-(oxiranylmethoxyethoxy)phenyl}-benzene,
1,4-bis{4-(3-oxiranylpropoxy)phenyl}-benzene,
1-{3-methyl-4-(3-oxiranylpropoxy)phenyl}-4-{4-(3-oxiranylpropoxy)phenyl}-benzene,
1,4-bis{4-(4-oxiranylbutoxy)phenyl}-benzene,
1-{3-methyl-4-(4-oxiranylbutoxy)phenyl}-4-{4-(4-oxiranylbutoxy)phenyl}-benzene,
1,4-bis{4-(5-oxiranylpentyloxy)phenyl}-benzene,
1-{3-methyl-4-(5-oxiranylpentyloxy)phenyl}-4-{4-(5-oxiranylpentyloxy)phenyl}-benzene,
1,4-bis{4-(o-oxiranylhexyloxy)phenyl}-benzene,
1-{3-methyl-4-(6-oxiranylhexyloxy)phenyl}-4-{4-(6-oxiranylhexyloxy)phenyl}-benzene,
1,4-bis{4-(8-oxiranyloctyloxy)phenyl}-benzene,
1-{3-methyl-4-(8-oxiranyloctyloxy)phenyl}-4-{4-(8-oxiranyloctyloxy)phenyl}-benzene,
1,4-bis{4-(oxiranylmethoxyethoxy)phenyl}-benzene,
1-{3-methyl-4-(oxiranylmethoxyethoxy)phenyl}-4-{4-(oxiranylmethoxyethoxy)phenyl}-benzene,
1,4-bis{4-(2-methyl-oxiranyl)methoxyethoxyphenyl}-benzene,
1-{3-methyl-4-(2-methyl-oxiranyl)methoxyethoxyphenyl}-4-{4-(2-methyl-oxiranyl)methoxyethoxyphenyl}-benzene,
1,4-bis{4-(3-methyl-oxiranyl)methoxyethoxyphenyl}-benzene and
1-{3-methyl-4-(3-methyl-oxiranyl)methoxyethoxyphenyl}-4-{4-(3-methyl-oxiranyl)methoxyethoxyphenyl}-benzene.

Among these epoxy compounds,
1,4-bis{4-(oxiranylmethoxyethoxy)phenyl}-1-cyclohexene,
1-{3-methyl-4-(oxiranylmethoxyethoxy)phenyl}-4-{4-(oxiranylmethoxyethoxy)phenyl}-1-cyclohexene,
1-{3-ethyl-4-(oxiranylmethoxyethoxy)phenyl}-4-{4-(oxiranylmethoxyethoxy)phenyl}-1-cyclohexene,
1-{3-n-propyl-4-(oxiranylmethoxyethoxy)phenyl}-4-{4-(oxiranylmethoxyethoxy)plenyl}-1-cyclohexene,
1-{3-isopropyl-4-(oxiranylmethoxyethoxy)phenyl}-4-{4-(oxiranyimethoxyethoxy)phenyl}-1-cyclohexene,
1-{3-n-butyl-4-(oxiranylmethoxyethoxy)phenyl}-4-{4-(oxiranylmethoxyethoxy)phenyl}-1-cyclohexene,
1-{3-sec-butyl-4-(oxiranylmethoxyethoxy)phenyl}-4-{4-(oxiranylmethoxyethoxy)phenyl}-1-cyclohexene and
1-{3-t-butyl-4-(oxiranylmethoxyethoxy)phenyl}-4-{4-(oxiranylmethoxyethoxy)phenyl}-1-cyclohexene are preferred.
The epoxy compound (2) can be produced, for example, by the method described in EP 1698625 A1.

The resin composition of the present invention contains an epoxy compound (1) and an epoxy compound (2). The resin composition is obtained by mixing the epoxy compound (1) and the epoxy compound (2) directly or in a solvent. Examples of the solvent include ketone solvents such as methyl ethyl ketone and methyl isobutyl ketone, aprotic polar solvents such as dimethyl sulfoxide and N-methyl pyrrolidone, ester solvents such as butyl acetate, and glycol solvents such as propylene glycol monomethyl ether.

A weight ratio of the epoxy compound (1) to the epoxy compound (2) in the resin composition, (epoxy compound (1)/epoxy compound (2)), is usually from 98/2 to 50/50, and preferably from 90/10 to 70/30.
The resin composition may contain two or more different kinds of epoxy compounds (2).

The resin composition may further contain a curing agent.
The curing agent may have at least two functional groups capable of causing a curing reaction with an epoxy group in the molecule and examples thereof include an amine type curing agent having amino groups as functional groups, a phenol type curing agent having hydroxyl groups as functional groups, and an acid anhydride type curing agent having carboxyl groups as functional groups. Among these curing agents, an amine type curing agent or a phenol type curing agent is preferred.

Examples of the amine type curing agent include aliphatic polyvalent amines having 2 to 20 carbon atoms such as ethylenediamine, trimethylenediamine, tetramethylenediamine, hexamethylenediamine, diethylenetriamine and triethylenetetramine; aromatic polyvalent amines such as p-xylenediamine, m-xylenediamine, 1,5-diaminonaphthalene, m-phenylenediamine, p-phenylenediamine, 4,4'-diaminodiphenylmethane, 4,4'-diaminodiphenylethane, 4,4'-diaminodiphenylpropane, 4,4'-diaminodiphenylether, 1,1-bis(4-aminophenyl)cyclohexane, 4,4'-diaminodiphenylsulfone and bins(4-aminophenyl)phenylmethane; alicyclic polyvalent amines such as 4,4'-diaminodicyclohexane and 1,3-bis(aminomethyl)cyclohexane; and dicyandiamide. Among these amine type curing agents, aromatic polyvalent amines are preferred, and 4,4'-diaminodiphenylmethane, 4,4'-diaminodiphenylethane, 1,5-diaminonaphthalene and p-phenylenediamine are more preferred.

Examples of the phenol type curing agent include phenol resin, phenol aralkyl resin (having a phenylene framework, diphenylene framework, etc.), naphthol aralkyl resin and polyoxystyrene resin. Examples of the phenol resin include resol type phenol resins such as aniline-modified resol resin and dimethyl ether resol resin; novolak type phenol resins such as phenol novolak resin, cresol novolak resin, tert-butyl phenol novolak resin and nonyl phenol novolak resin; special phenol resins such as dicyclopentadiene-modified phenol resin, terpene-modified phenol resin and triphenol methane type resin. Examples of the poloxystyrene resin include poly(p-oxystyrene).

Examples of the acid anhydride type curing agent include maleic anhydride, phthalic anhydride, pyromellitic anhydride and trimellitic anhydride.

The curing agent is used in such an amount that the total amount of functional groups capable of causing a curing reaction with an epoxy group is usually 0.5 to 1.5 equivalent times, and preferably from 0.9 to 1.1 equivalent times based on the total amount of epoxy groups in the epoxy compound (1) and the epoxy compound (2) in the resin composition.

The resin composition may further contain said solvents, another epoxy compounds and various additives. Examples of the additive include silica powders such as fused crushed silica powder, fused spherical silica powder, crystal silica powder and secondary aggregated silica powder; fillers such as alumina, aluminum nitride, boron nitride, silicon nitride, silicon carbide, titanium white, aluminum hydroxide, magnesia, talc, clay, mica and glass fiber; metals such as copper, aluminum and iron; curing accelerators such as triphenylphosphine, 1,8-azabicyclo[5.4.0]-7-undecene and 2-methylimidazole; coupling agents such as γ-glycidoxypropyltrimethoxysilane; colorants such as carbon black; low-stress components such as silicone oil and silicone rubber; mold release agents such as natural wax, synthetic wax, higher fatty acid or metal salt thereof, and paraffin; and antioxidants. Among these additives, fillers are preferred. The content of another epoxy compounds and additives may be the content which does not adversely affect desired performances of the cured resin obtained by curing the resin composition of the present invention.

The cured resin can be obtained by curing a resin composition containing a curing agent.
The curing temperature is usually from 120°C to 200°C.
Examples of the method of producing the cured resin include a method of curing a resin composition by heating to a predetermined temperature; a method of melting said resin composition with heating, injecting the melt into a mold and heating the mold, followed by molding; a method of melting said resin composition, injecting the resultant melt in a preheated mold and curing the melt; a method of filling a mold with a powder, which is obtained by partially curing said resin composition and grinding the resultant partially cured resin composition, and melt-molding the filled powder; and a method of optionally dissolving said resin composition in a solvent, partially curing with stirring, casting the resultant solution, removing the solvent through draft drying etc and optionally heating for a predetermined time while applying a pressure using a press etc.

Also, a prepreg can be produced by optionally diluting a resin composition containing a curing agent with a solvent, applying or impregnating a base material with the resin composition and semi-curing the epoxy compound in the base material through heating the applied or impregnated base material. Examples of the base material include woven or nonwoven fabric made of an inorganic fiber, such as glass fiber woven fabric; and woven or nonwoven fabric made of an organic fiber such as polyester fiber. Using the prepreg, a laminate can be easily produced by a conventional method.

### Examples

Hereinafter, the present invention is further illustrated in detail by referring to Examples, but the present invention is not limited to Examples.

### Example 1

1-{2-methyl-4-(oxiranylmethoxy)phenyl}-4-{4-(oxiranylmethoxy)phenyl}-1-cyclohexene (compound A) as an epoxy compound (1) and 1-{3-methyl-4-(oxiranylmethoxyethoxy)phenyl}-4-{4-(oxiranylmethoxyethoxy)phenyl}-1-cyclohexene (compound B) as an epoxy compound (2) were mixed to prepare a resin composition (composition X), To the resultant composition X, 4,4'-diaminodiphenylmethane (DDM) as a curing agent, an alumina powder as a filler and methyl ethyl ketone as a solvent were added to prepare a resin composition (composition Y). A ratio of a compound A to a compound B in the composition Y was 80:20 in terms of an epoxy equivalent ratio, and 77:23 in terms of a weight ratio. Also, a ratio of the total of the compound A and the compound B to the curing agent was 1:1 in terms of an equivalent ratio (epoxy group/amino group). Also, the filler was blended so that a volume ratio of the filler to a cured resin obtained by curing the composition Y was 70%. The composition Y was applied on a copper foil, one surface (top surface) of which was roughed, as a base material in a predetermined thickness by casting and then dried by heating to obtain a prepreg. The prepreg was placed so that the resin-applied surface faced upward, and a copper foil, one surface (bottom surface) of which was roughed, was laid thereon, and then the prepreg was cured by vacuum heat press at 145°C, thus bonding the prepreg and the copper foil. As a result of complete curing by heating at a temperature of 205°C for 2 hours, a sheet-like cured resin was obtained. Test pieces were cut out from the resultant cured resin and the copper foils existing on both surfaces were removed by acid etching, and then only a sheet-like resin layer was taken out. Using an apparatus by a Flash method (Xe Flash Analyzer, Model LFA447 manufactured by NETZSCH Instruments, Inc. in conformity with ASTM E1461), a thermal diffusion factor of the resin layer was measured and then a thermal conductivity in a thickness direction was determined by multiplication of the resultant thermal diffusion factor by a density measured by an Archimedes's method and a specific heat measured by a DSC method.

### Example 2

In the same manner as in Example 1, except that vacuum heat press was performed at 160°C, a sheet-like cured resin was obtained. Test pieces were cut out from the resultant cured resin, and then a thermal conductivity was measured in the same manner as in Example 1.

### Comparative Example 1

In the same manner as in Example 1, except that only the compound A was used in place of the compound A and the compound B in Example 1, a sheet-like cured resin was obtained. Test pieces were cut out from the resultant cured resin, and then a thermal conductivity was measured in the same manner as in Example 1.

### Comparative Example 2

In the same manner as in Example 2, except that only the compound A was used in place of the compound A and the compound B in Example 2, a sheet-like cured resin was obtained. Test pieces were cut out from the resultant cured resin, and then a thermal conductivity was measured in the same manner as in Example 1.
The evaluation results of Examples 1 and 2 as well as Comparative Examples 1 and 2 are summarized in Table 1.

**Table 1**

| | | Example 1 | Example 2 | Comparative Example 1 | Comparative Example 2 |
|---|---|---|---|---|---|
| Epoxy compound | Compound A | 77 | 77 | 100 | 100 |
| (weight ratio) | Compound B | 23 | 23 | 0 | 0 |
| Curing agent | | DDM | DDM | DDM | DDM |
| Vacuum press temperature (°C) | | 145 | 160 | 145 | 160 |
| Thermal conductivity (W/mK) | | 7.9 | 8.0 | 7.2 | 5.5 |

When Comparative Example 1 is compared with Comparative Example 2, it is apparent that the thermal conductivity of the cured resin of Comparative Example 2, in which the vacuum press temperature was high, was lower than that of the cured resin of Comparative Example 1. It is considered that, in Comparative Example 2, the curing temperature (vacuum press temperature) was not within a curing temperature range where a cured resin showing liquid crystallinity could be obtained from a resin composition containing only a compound A, and a sufficient conformation was not formed upon curing. It is considered that, in Comparative Example 1, the curing temperature was within a curing temperature range where a cured resin showing liquid crystallinity could be obtained, and thus the thermal conductivity was higher than that of Comparative Example 2.

In contrast, the cured resins obtained in Example 1 and Example 2 had high thermal conductivities even if their curing temperature were different. It is considered that blending of a compound B widened a curing temperature range where a cured resin showing liquid crystallinity could be obtained, and thus a sufficient conformation was formed. Furthermore, the thermal conductivities of the cured resins obtained in Example 1 and Example 2 were higher than that of the cured resin of Comparative Example 1. It is considered that it became easier to form a conformation by blending of a compound B even within a curing temperature range where a cured resin showing liquid crystallinity could be obtained.

### Industrial Applicability

The cured resin of the present invention shows liquid crystallinity and also has a high thermal conductivity, and is therefore useful as insulating materials of printed circuit boards etc to which high heat dissipation properties are requited.

## Claims

1. A resin composition comprising an epoxy compound denoted by the formula (1): 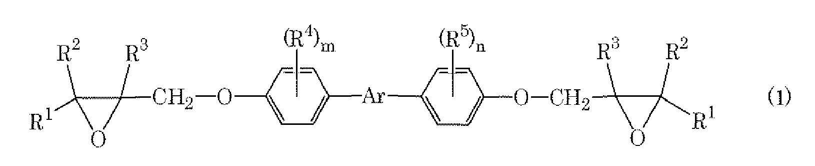 wherein R¹, R², R³ , R⁴ and R⁵ are the same or different and each denotes a hydrogen atom or an alkyl group having 1 to 8 carbon atoms, m and n denote an integer of 0 to 4, and when m denotes an integer of 2 or more, all of R⁴ may be the same group or different groups, and when n denotes an integer of 2 or more, all of R⁵ may be the same group or different groups, Ar denotes any one of divalent groups denoted by the following formulas: 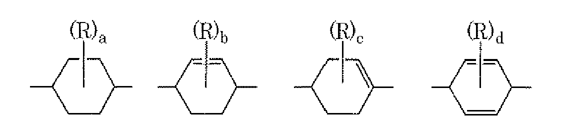 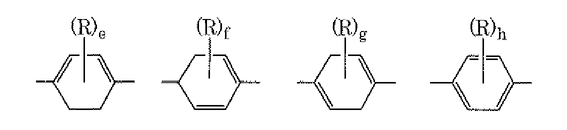 wherein R denotes a hydrogen atom or an alkyl group having 1 to 8 carbon atoms, a denotes an integer of 1 to 8, b, e and g denote an integer of 1 to 6, c denotes an integer of 1 to 7, d and h denote an integer of 1 to 4, f denotes an integer of 1 to 5, and when a to h denote an integer of 2 or more, all of R may be the same group or different groups, and an epoxy compound denoted by the formula (2): 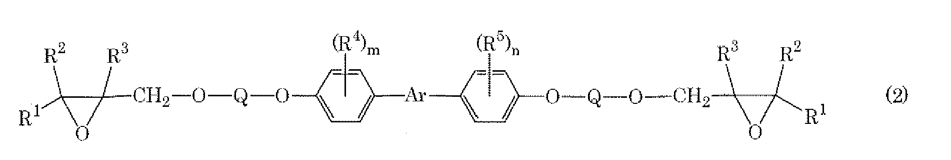 wherein R¹, R², R³, R⁴, R⁵, m, n and Ar are the same as defined above, Q denotes a straight-chain alkylene group having 1 to 8 carbon atoms, methylene groups composing said straight-chain alkylene group are optionally substituted with an alkyl group having 1 to 8 carbon atoms and -O- or -N(R⁶)-is optionally inserted between the methylene groups, wherein R⁶ denotes a hydrogen atom or an alkyl group having 1 to 8 carbon atoms.

2. The resin composition according to claim 1, wherein a weight ratio of the epoxy compound denoted by the formula (1) to the epoxy compound denoted by the formula (2), (epoxy compound denoted by the formula (1)/(epoxy compound denoted by the formula (2)), is from 98/2 to 50/50.

3. The resin composition according to claim 1, wherein the epoxy compound denoted by the formula (1) is an epoxy compound denoted by the formula (3): 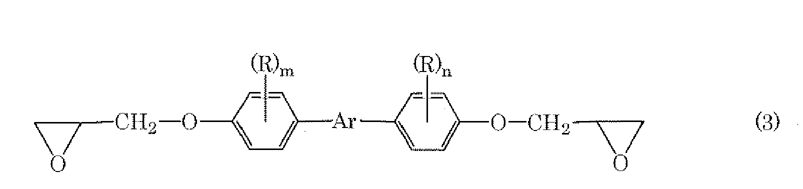 wherein Ar denotes any one of divalent groups denoted by the following formulas: 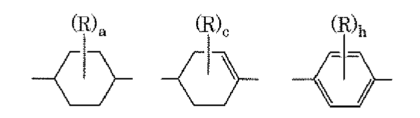 and R, a, c, h, m and n are the same as defined above.

4. The resin composition according to claim 3, wherein Ar is 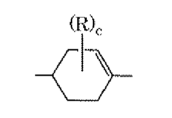 in the formula (3).

5. The resin composition according to any one of claims 1 to 4, further containing a curing agent.

6. The resin composition according to claim 5, further containing a filler.

7. A cured resin obtained by curing the resin composition according to claim 5.

8. The cured resin according to claim 7, wherein the curing temperature is from 120°C to 200°C.

9. A cured resin obtained by curing the resin composition according to claim 6.

10. The cured resin according to claim 9, wherein the curing temperature is from 120°C to 200°C.

11. A prepreg obtained by applying or impregnating a base material with the resin composition according to any one of claims 1 to 4 and semi-curing the applied or impregnated base material.
